Europäisches Patentamt

European Patent Office

Office européen des brevets

(11) Numéro de publication: **0 409 681 A1**

# DEMANDE DE BREVET EUROPEEN

(21) Numéro de dépôt: 90401824.9

(22) Date de dépôt: 26.06.90

(51) Int. Cl.⁵: **H01L 21/338**, H01L 21/28, H01L 21/027, H01L 29/812

(30) Priorité: 21.07.89 FR 8909888

(43) Date de publication de la demande:
23.01.91 Bulletin 91/04

(84) Etats contractants désignés:
DE GB NL

(71) Demandeur: THOMSON COMPOSANTS MICROONDES
51, Esplanade du Général de Gaulle
F-92800 Puteaux(FR)

(72) Inventeur: Pham Ngu Tung,
THOMSON-CSF SCPI Cédex 67
F-92045 Paris la Défense(FR)

(74) Mandataire: Taboureau, James et al
THOMSON-CSF SCPI
F-92045 Paris La Défense Cédex 67(FR)

(54) Procédé de fabrication de grilles hyperfines.

(57) L'invention concerne la fabrication des transistors ayant des dimensions de grilles submicroniques.

Le procédé utilise un sillon (6) gravé dans une couche de résine (5) déposée sur le substrat semiconducteur (1 + 2). Ce sillon, de longueur (L) la plus faible possible selon la technologie utilisée, est recouvert d'une couche isotropique de silice (7), d'épaisseur (e) régulière. Par gravure ionique de la silice, on crée dans le fond du sillon (6) une ouverture réduite (12), qui peut atteindre 0,2 micron.

Application à la fabrication de dispositifs semiconducteurs submicroniques, avec des moyens de masquage optiques.

FIG.2

## PROCEDE DE FABRICATION DE GRILLES HYPERFINES.

La présente invention concerne un procédé de fabrication de grilles hyperfines, pour les transistors de performances élevées, tels que les transistors hyperfréquences. Ce procédé permet d'obtenir des grilles dont la longueur est inférieure à la limite permise par la technologie de masquage utilisée.

On sait que pour les transistors à effet de champ, on appelle longueur de la grille la distance correspondante mesurée selon la direction source-drain. Cette longueur est importante car elle est directement liée à la fréquence extrême d'oscillation du transistor, puisqu'elle correspond au temps de transit des électrons entre source et drain. Plus elle est courte, plus vite oscille le transistor, mais les techniques de masquage utilisées pour réaliser cette grille présentent une limite technologique qu'on ne sait pas franchir. Actuellement, en première approximation, les grilles de longueur au moins égale à 7 micron sont faites par masquage optique, et les grilles de longueur inférieure, 0,2 ou 0,3 micron, sont faites par inscription directe par faisceau d'électrons.

Le masquage optique est bien connu, rapide, collectif et économique, mais la diffraction de la lumière empêchera toujours de franchir les limites imposées par la physique. L'inscription directe par faisceau d'électrons est plus précise, mais elle est moins industrielle elle met en oeuvre un matériel côuteux, et elle est plus lente puisque chaque transistor est inscrit séparément.

Le procédé selon l'invention permet de réaliser des grilles hyperfines, de l'ordre de 0,2 micron de longueur, donc aussi fines que celles inscrites directement par faisceau d'électrons. Ce résultat est obtenu en gravant dans un masque de résine photosensible un sillon de faible longueur, dont les parois sont ensuite recouvertes d'une couche minérale déposée de façon isotrope. L'épaisseur de cette couche est parfaitement connue et contrôlable, et l'ouverture restante est égale à la longueur du sillon moins deux épaisseurs de couche minérale. Par gravure de la couche minérale, on ouvre dans le masque une fenêtre dont la longueur est elle aussi égale à la longueur du sillon moins deux épaisseurs de couche minérale.

Ce qui signifie que si un procédé optique est utilisé pour définir le sillon, le résultat obtenu va au-delà des limites inférieures du procédé de masquage optique. Et si un procédé électronique est utilisé pour définir un sillon relativement large, 0,5 micron par exemple, le résultat est obtenu avec un meilleur rendement que si on avait tenté de graver directement une fenêtre de 0,2 micron par exemple. Parce que le rendement d'un procédé électronique chute avec la dimension de la gravure effectuée.

De façon plus précise l'invention concerne un procédé de fabrication de grilles hyperfines, pour les transistors hyperfréquences, par masquage dans une couche de résine photosensible déposée sur un substrat qui comprend déjà les couches constitutives des transistors, ce procédé étant caractérisé en ce qu'il consiste à ouvrir dans la couche de résine un sillon de longueur L, comprise entre deux parois opposées, et à diminuer cette longueur au moyen d'une couche isotropique minérale, d'épaisseur connue, déposée sur les deux dites parois, puis à graver le fond du sillon, ainsi rétréci de deux épaisseurs de couche minérale.

L'invention sera mieux comprise par la description plus détaillée qui suit d'un exemple d'application, en relation avec les figures jointes qui représentent différentes étapes au cours du processus, les cinq figures étant toutes relatives à l'invention.

Le procédé selon l'invention est applicable aussi bien aux semiconducteurs sur silicium qu'à ceux sur des matériaux rapides du groupe III-V, tel que GaAs. Cependant, afin de rendre l'exposé plus clair, le procédé sera exposé sur le cas, non limitatif, d'un transistor à effet de champ sur GaAs.

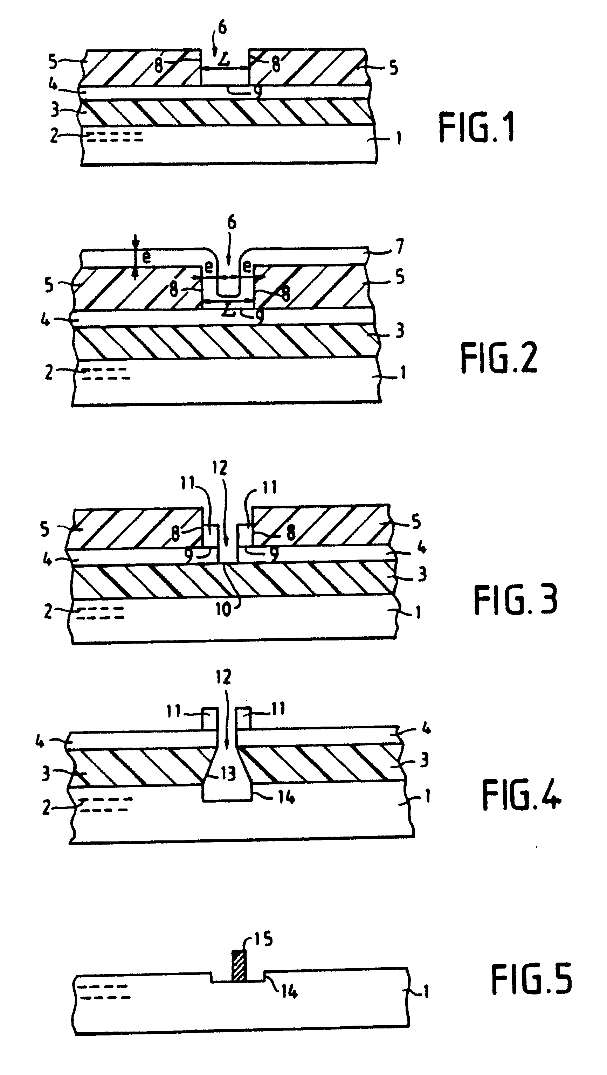

Le procédé s'applique sur une rondelle 1 de matériau semiconducteur, sur laquelle les différentes couches constitutives des transistors ont déjà été formées, par épitaxie ou implantation par exemple. Sur la figure 1, ces couches sont symbolisées par des pointillés en 2, et il n y a pas de raison d'entrer dans le détail, car elles sortent du domaine de l'invention. La formation des électrodes de grille, source et drain étant les opérations finales, il est évident que les transistors sont déjà formés au sein du substrat 1.

La première opération consiste à déposer sur le substrat 1, dans l'ordre :
- une première couche 3 de résine photosensible, sur une épaisseur supérieure ou égale à 0,5 micron,
- une couche minérale d'arrêt 4, sur une épaisseur supérieure ou égale à 0,1 micron. Cette couche est en silice, en nitrure de silicium ou en nitrure d'aluminium : elle est déposée par plasma ou pulvérisation cathodique, et a pour objectif de séparer les deux couches de résine photosensible,
- une deuxième couche 5 de résine photosensible, négative sur une épaisseur supérieure ou égale à 0,5 micron.

Centré sur l'emplacement de la future grille du transistor, un sillon 6 est ouvert dans la deuxième couche de résine 5. Ce sillon 6 a une longueur L -mesurée selon la même direction que la longueur d'une grille- qui est préférablement égale à l'épaisseur de la deuxième couche de résine 5 : il faut donc donner à celle-ci une épaisseur en relation avec la longueur de grille à réaliser.

Le sillon 6 a des dimensions qui permettent de l'obtenir soit par masquage optique, mais on est alors en limite inférieure de technologie, vers 1 micron, soit par masquage électronique : si la longueur L = 0,6 micron par exemple, le masquage par faisceau d'électrons a encore un rendement de 100 %. C'est aux plus faibles dimensions que le rendement chute.

Ensuite, en figure 2, une deuxième couche minérale 7 est déposée sur la surface de la deuxième résine 5 et sur les murs 8 et le fond 9 du sillon 6. Cette couche est en même matériau $Si\ O_2$, $Si_3\ N_4$ ou $AIN$ que la première couche 4.

Le procédé de dépôt est obligatoirement isotrope : la pulvérisation cathodique ou le dépôt chimique sous plasma -PECVD, pour Plasma Enhanced Chemical Vapour Deposition -assurent une grande régularité de l'épaisseur "e" de la couche de silice 7, en particulier sur les murs 8 du sillon 6. Cette épaisseur "e" est une fonction directe de la longueur de la grille à réaliser. L'ouverture laissée libre du sillon 6 est égale à L-2e : si L = 0,6 micron et e = 0,2 micron, la grille réalisée aura une longueur de 0,2 micron.

En figure 3, le fond du sillon 6 est percé, par gravure directive de la silice par plasma en présence de $C_3\ F_8$ + $CHF\ 3$, selon le procédé connu sous le nom RIE (Reactive Ion Etching). Au cours de cette gravure, la couche 7 de silice, qui était déposée sur la face principale de la deuxième couche de résine 5 et sur le fond 9 du sillon 6, est éliminée en premier. Puis en poursuivant la gravure, la première couche de silice 4 est à son tour percée, jusqu'à atteindre en 10 la première couche de résine 3. Durant cette seconde phase de la gravure , la couche 7 qui s'appuyait sur les murs 8 du sillon 6 est partiellement gravée : il en demeure des murets de silice 11.

Parce que la méthode de RIE utilisée est directive, cette gravure a permis de percer le fond du sillon 6 en conservant les cotes de l'ouverture rétrécie : le sillon 6, large (0,6 micron), de la figure 1 est remplacé par une ouverture 12, étroite (0,2 micron) en figure 3.

La fonction de la première couche de résine 3 apparaît maintenant, la gravure par RIE en présence de $C_3\ F_8$ + $CHF_3$ endommage la surface de GaAs dans la rondelle 1, et toute la gravure est effectuée avec la couche de résine 3 comme protection de GaAs.

L'opération suivante, en figure 4, consiste à graver la première couche de résine 3, jusqu'à atteindre la surface du substrat 1. Cette gravure se fait par plasma d'oxygène : elle est sélective, ne modifie pas les dimensions de l'ouverture 12, et n'interfère que très peu avec la surface de GaAs du substrat 1.

A titre secondaire, les murs 13 de l'ouverture dans la résine 3 sont sous-gravés par rétro-diffusion des ions, et le fonds du puits gravé dans la résine 3 est plus large que l'ouverture 12. Ceci est mis à profit pour graver chimiquement les couches superficielles 2 dans le substrat 1, y créant un "enfoncement" 14, ce qui permet d'ajuster la tension de seuil $V_T$ des transistors.

La métallisation de grille 15 est déposée par vaporisation, par exemple, de Ti, Pt et Au à travers l'ouverture 12, dont les bords servent de masque d'autoalignement. Puis les restes de silice 11 et 4 et la première couche de résine 3 sont supprimés par dissolution et ultra-sons, selon la méthode connue sous le nom "lift-off" : il reste une grille 15, de longueur inférieure à la limite des moyens de masquage utilisés. Eventuellement, elle est déposée dans un "recess", comme montré en figure 5. Il ne reste plus qu'à déposer les métallisations de source et drain pour compléter le transistor.

A titre d'exemple non limitatif, cette méthode appliquée à un masquage optique du sillon 6 permet de réduire la longueur de grille de 1 micron à 0,5 micron, avec des murs de silice 11 de 0,25 micron d'épaisseur. Avec un masquage par faisceau d'électrons, on peut descendre jusque 0,2 micron de longueur de grille. Il ne faut pas descendre en dessous de cette limite car l'ouverture 12 se bouche alors, au cours du dépôt de grille 15.

## Revendications

1 - Procédé de fabrication de grilles hyperfines, pour les transistors hyperfréquences, par masquage dans une couche de résine photosensible (5) déposée sur un substrat (1) qui comprend déjà les couches (2) constitutives des transistors, ce procédé étant caractérisé en ce qu'il consiste à ouvrir dans la couche de résine (5) un sillon (6), de longueur (L) comprise entre deux parois opposées (8), et à diminuer cette longueur (L) au moyen d'une couche (7) isotropique minérale, d'épaisseur connue (e), déposée sur les deux dites parois puis à graver le fond (9) du sillon (6), ainsi rétréci de deux épaisseurs de couche minérale.

2 - Procédé de fabrication de grilles selon la revendication 1, caractérisé en ce qu'il comporte les étapes suivantes :
- sur un substrat (1) de matériau semiconducteur, ayant préalablement été traité pour y réaliser au moins un transistor, dépôt d'une première couche de résine (3) photosensible, d'une première couche minérale (4) puis d'une deuxième couche de résine (5)
- masquage et gravure d'un sillon (6) dans la deuxième couche de résine (5)

- dépôt, par un procédé isotropique, d'une deuxième couche minérale (7) en particulier sur les parois (8) et le fond (9) du sillon (6),

- gravure directive des première et deuxième couches minérales (4 + 7), de façon à obtenir une ouverture réduite (12) dans le fond du sillon (6), cette ouverture étant délimitée par les restes (11) de la deuxième couche minérale (7) déposés sur les parois (8) du sillon (6)

- gravure de la première couche de résine (3), à travers l'ouverture réduite (12) précédemment gravée, avec effet de sous-gravure (13)

- dépôt par pulvérisation cathodique de l'électrode de grille (15), en utilisant l'ouverture réduite (12) comme masque d'autoalignement.

3 - Procédé de fabrication de grilles selon la revendication 2, caractérisé en ce que la méthode de dépôt isotropique de la deuxième couche (7) minérale est une méthdoe de dépôt chimique en phase vapeur, sous plasma (PECVD).

4 - Procédé de fabrication de grilles selon la revendication 2, caractérisé en ce que la méthode du dépôt isotropique de la deuxième couche minérale (7) est une méthode de pulvérisation cathodique.

5 - Procédé de fabrication de grilles selon la revendication 2, caractérisé en ce que les couches minérales (4,7) sont gravées de façon directive par gravure ionique sous plasma de $C_3F_8$ + $CHF_3$

6 - Procédé de fabrication de grilles selon la revendication 2, caractérisé en ce que les couches de résine (3,5) sont gravées par gravure ionique en présence d'oxygène.

7 - Procédé de fabrication de grilles selon la revendication 2, caractérisé en ce que les couches minérales (4,7) sont choisies parmi SiO2, $Si_3N_4$, AlN.

8 - Procédé de fabrication de grilles selon la revendication 2, caractérisé en ce que, avant le dépôt de l'électrode de grille (15), les couches (2) de matériaux semiconducteurs sont gravées chimiquement (14), en vue d'ajuster les tensions de seuil des transistors.

9 - Procédé de fabrication de grilles selon l'une quelconque des revendications 1 à 8, caractérisé en ce que les matériaux semiconducteurs sont soit le silicium soit l'arséniure de gallium.

FIG.1

FIG.2

FIG.3

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 178 181  (TEKTRONIX INC.)<br>* Figures 2,3 *<br>--- | 1,2,9 | H 01 L  21/338<br>H 01 L  21/28<br>H 01 L  21/027<br>H 01 L  29/812 |
| A | EP-A-0 308 939  (SIEMENS AG)<br>* Figures 1-6 *<br>--- | 1,2,7-9 | |
| A | JAPANESE JOURNAL OF APPLIED PHYSICS/PART 1: REGULAR PAPERS & SHORT NOTES, vol. 27, no. 4, April 1988, pages 653-657, Tokyo, JP; T. USAGAWA et al.: "Photo-CVD SiN assisted self-aligned metal contact technology for high-speed GaAs devices - Recess gate structure with high breakdown voltage for GaAs FETs"<br>* Figure 2 *<br>----- | 1,7,9 | |

DOMAINES TECHNIQUES
RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 09-10-1990 | GELEBART J.F.M. |

EPO FORM 1503 03.82 (P0402)